# EUROPEAN PATENT APPLICATION

(11) **EP 4 516 870 A1**
(43) Date of publication of application: **05.03.2025**
(21) Application number: 23796170.1
(22) Date of filing: 17.04.2023
(51) Int. Cl.: C09J 163/00, C09J 7/30, C09J 11/04, C09J 11/08, H01L 21/301, H01L 21/52

(54) **ADHESIVE COMPOSITION, FILM-LIKE ADHESIVE, SEMICONDUCTOR PACKAGE USING FILM-LIKE ADHESIVE, AND METHOD FOR MANUFACTURING SAME**

(30) Priority: 28.04.2022 JP 2022075368
(71) Applicant: FURUKAWA ELECTRIC CO., LTD., Tokyo 100-8322 (JP)
(72) Inventor: TOKUHISA, Kenji, Tokyo 100-8322 (JP)
(74) Representative: Forstmeyer, Dietmar
(86) International application number: PCT/JP2023/015341
(87) International publication number: WO 2023/210427

(57) **Abstract**

An adhesive composition containing: an epoxy resin (A) having a fused ring structure; an epoxy resin curing agent (B); a polyrotaxane compound (C); and a polymer component (D), wherein the polyrotaxane compound (C) is contained in a content of 5 to 15 parts by mass based on total 100 parts by mass of contents of the epoxy resin (A) and the polymer component (D); a film adhesive using the adhesive composition; and a semiconductor package and a producing method thereof.

## Description

### FIELD OF THE INVENTION

The present invention relates to an adhesive composition and a film adhesive, and a semiconductor package using the film adhesive and a producing method thereof.

### BACKGROUND OF THE INVENTION

Stacked MCPs (Multi Chip Package) in which semiconductor chips are multistacked have recently been widely spread. Such stacked MCPs are mounted on memory packages for mobile phones or portable audio devices. Further, along with multi-functionality of mobile phones and the like, high densification and high integration of the package have also been advanced. Along with such advance, multistacking of the semiconductor chips has been advanced.

Thermosetting film adhesives (die attach films, die bond films) have been used for bonding a circuit board and a semiconductor chip or bonding semiconductor chips in the production process of such a memory package. Along with multistacking of the chips, the die attach film is required to have an increasingly thinner form. Also, as miniaturization in the wiring rule of the wafer has been advanced, heat is more likely to be generated on the surface of the semiconductor element. Therefore, in order to dissipate heat to the outside of the package, a thermally conductive filler is blended in the die attach film to realize high thermal conductivity.

As a material of a thermosetting film adhesive intended for so-called die attach film applications, for example, a composition obtained by combining a curable resin with a weight-average molecular weight of less than 10000, a curing agent, and a eucryptite is known (see, for example, Patent Literature 1).

### CITATION LIST

### PATENT LITERATURE

Patent Literature 1: JP-A-2021-24963 ("JP-A" means an unexamined published Japanese patent application)

### SUMMARY OF INVENTION

### TECHNICAL PROBLEM

The semiconductor package includes members made of various materials, such as a substrate (e.g., a semiconductor, glass), a lead frame (metal), a circuit, an adhesive layer, and a sealing layer. This may cause warping of the semiconductor package due to the difference in the thermal expansion coefficient of each member. As the semiconductor package becomes smaller and thinner, the tendency increases. In addition, in a multistage package having a large number of stacked layers, the influence of warping is larger than that of a single-stage semiconductor package. The occurrence of warping in the semiconductor package may result in various problems during assembly and use, such as poor connection between the external terminal and the mounting substrate, occurrence of cracks in the internal structure, and breakage of wires.

Among materials constituting a semiconductor package, a resin-containing material has a relatively large thermal expansion coefficient with respect to a metal material, and thus, various studies have been conducted to reduce the thermal expansion coefficient. For example, Patent Literature 1 points out a problem in the case of adopting an inorganic filler as a means for reducing thermal expansion, and describes that the coefficient of thermal expansion can be reduced by a composition using a curable resin having a specific weight-average molecular weight, a curing agent, and a eucryptite as a filler. However, the composition described in Patent Literature 1 above has production restrictions in terms of using a special inorganic filler.

On the other hand, when a resin-containing material is used as an adhesive or a sealant, it is required to exhibit sufficient adhesion to an adherend. Conventionally, it has been known that the adhesion strength is reduced by including a large amount of inorganic filler, and it has been difficult to achieve both reduction of warping and excellent adhesion strength by a method using an inorganic filler.

The present invention provides a film adhesive that can effectively suppress warping and exhibits excellent strength of adhesion to an adherend, and an adhesive composition suitable for preparation of this film adhesive. In addition, the present invention provides a semiconductor package using this film adhesive and a producing method thereof.

### SOLUTION TO PROBLEM

As a result of intensive research in view of the above problems, the present inventors have found that when a film adhesive is prepared using an adhesive composition containing an epoxy resin, an epoxy resin curing agent, and a polymer component, the above problems can be solved by adopting an epoxy resin having a fused ring skeleton as the epoxy resin and including a polyrotaxane compound in a specific amount.

The present invention is based on the above findings, and after further investigation, has been completed.

The above problems of the present invention have been solved by the following means.
[1] An adhesive composition, containing:
   an epoxy resin (A) having a fused ring structure;
   an epoxy resin curing agent (B);
   a polyrotaxane compound (C); and
   a polymer component (D),
   wherein the polyrotaxane compound (C) is contained in a content of 5 to 15 parts by mass based on total 100 parts by mass of contents of the epoxy resin (A) and the polymer component (D).
[2] The adhesive composition described in [1], wherein the epoxy resin (A) includes a dicyclopentadiene-type epoxy resin.
[3] The adhesive composition described in [1] or [2], wherein the polymer component (D) includes a phenoxy resin.
[4] The adhesive composition described in any one of [1] to [3], including (E) an inorganic filler.
[5] A film adhesive, which is obtainable from the adhesive composition described in any one of [1] to [4].
[6] The film adhesive described in [5], which has a thickness in a range of 1 to 80 µm.
[7] A method of producing a semiconductor package, including:
   a first step of providing an adhesive layer by thermocompression bonding the film adhesive described in [5] or [6] to a back surface of a semiconductor wafer in which a semiconductor circuit is formed on a surface, and providing a dicing film with the adhesive layer interposed between the back surface and the dicing film;
   a second step of integrally dicing the semiconductor wafer and the adhesive layer to obtain a semiconductor chip with an adhesive layer, the semiconductor chip including the semiconductor chip and a piece of the film adhesive on the dicing film;
   a third step of removing the dicing film from the semiconductor chip with an adhesive layer and thermocompression bonding the semiconductor chip with an adhesive layer and a circuit board via the adhesive layer; and
   a fourth step of thermally curing the adhesive layer.
[8] A semiconductor package, which is obtainable by the producing method described in [7].
[9] A wire bonding-type semiconductor package including a thermally cured product of the film adhesive described in [5] or [6].

In the present invention, the numerical ranges expressed with the term "to" refer to ranges including, as the lower limit and the upper limit, the numerical values before and after the term "to".

### ADVANTAGEOUS EFFECTS OF INVENTION

The film adhesive of the present invention can suppress warping, and exhibits excellent strength of adhesion to an adherend. The adhesive composition of the present invention is suitable for providing the film adhesive.

The method of producing a semiconductor package according to the present invention makes it possible to produce a semiconductor package which is hardly warped and has excellent adhesion reliability.

### BRIEF DESCRIPTION OF DRAWINGS

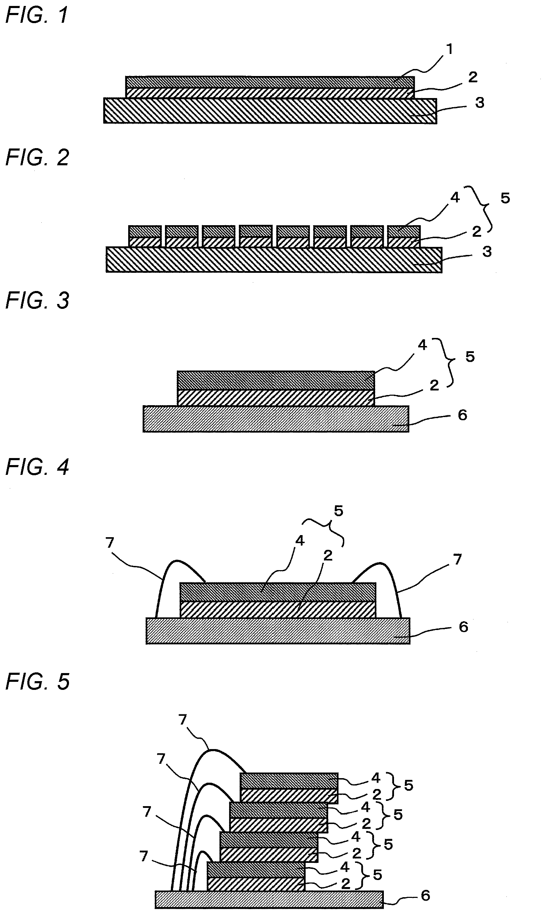

{FIG. 1}
   FIG. 1 is a schematic longitudinal cross-sectional view illustrating a preferred embodiment of a first step of a method of producing a semiconductor package of the present invention.
{FIG. 2}
   FIG. 2 is a schematic longitudinal cross-sectional view illustrating a preferred embodiment of a second step of a method of producing a semiconductor package of the present invention.
{FIG. 3}
   FIG. 3 is a schematic longitudinal cross-sectional view illustrating a preferred embodiment of a third step of a method of producing a semiconductor package of the present invention.
{FIG. 4}
   FIG. 4 is a schematic longitudinal cross-sectional view illustrating a preferred embodiment of a step of connecting a bonding wire of a method of producing a semiconductor package of the present invention.
{FIG. 5}
   FIG. 5 is a schematic longitudinal cross-sectional view illustrating an example of an embodiment of multistacking of a method of producing a semiconductor package of the present invention.
{FIG. 6}
   FIG. 6 is a schematic longitudinal cross-sectional view illustrating an example of an embodiment of another multistacking of a method of producing a semiconductor package of the present invention.
{FIG. 7}
   FIG. 7 is a schematic longitudinal cross-sectional view illustrating a preferred embodiment of a semiconductor package produced by a method of producing a semiconductor package of the present invention.

### DESCRIPTION OF EMBODIMENTS

### [Adhesive composition]

The adhesive composition of the present invention is a composition suitable for forming a film adhesive of the present invention.

The adhesive composition of the present invention contains an epoxy resin (A) having fused ring structure, an epoxy resin curing agent (B), a polyrotaxane compound (C), and a polymer component (D). In addition, the content of the polyrotaxane compound (C) is controlled to 5 to 15 parts by mass based on total 100 parts by mass of contents of the epoxy resin (A) and the polymer component (D). The adhesive composition of the present invention may further contain an inorganic filler (E).

The adhesive composition of the present invention is hardly warped in a laminate with an adherend, and has excellent strength of adhesion to the adherend.

Hereinafter, each component contained in the adhesive composition will be described.

### <(A) Epoxy resin having fused ring structure>

The epoxy resin (A) having a fused ring structure (hereinafter, also simply referred to as an epoxy resin (A)) is a thermosetting resin having an epoxy group, and has a fused ring structure in its molecule. The number of rings constituting the fused ring structure is preferably from 2 to 7, more preferably from 2 to 5, still more preferably from 2 to 4, still more preferably from 2 or 3, and particularly preferably 2. In addition, each ring constituting the fused ring structure may have a bridge structure. The number of ring members in each ring constituting the fused ring structure is preferably 5 and/or 6 (e.g., a dicyclopentadiene structure is a fused ring with a 5-membered ring and a 6-membered ring, and the 6-membered ring has a bridge structure).

Examples of the fused ring structure of the epoxy resin (A) include a dicyclopentadiene structure, a fluorene structure (preferably a fluorene bisphenol structure), or a naphthalene structure (preferably including a naphthol structure, a naphthalenediol structure). Among them, a dicyclopentadiene structure or a naphthalene structure is preferable. That is, the epoxy resin (A) preferably contains a dicyclopentadiene-type epoxy resin and/or a naphthalene-type epoxy resin, and more preferably contains a dicyclopentadiene-type epoxy resin.

The epoxy equivalent of the epoxy resin (A) is preferably 500 g/eq or less. The epoxy resin (A) may be liquid, solid, or semi-solid. The liquid in the present invention means that the softening point is less than 25°C. The solid means that the softening point is 60°C or more. The semi-solid means that the softening point is between the softening point of the liquid and the softening point of the solid (25°C or more and less than 60°C). As the epoxy resin (A) used in the present invention, the softening point is preferably 100°C or less from the viewpoint of obtaining a film adhesive that can reach low melt viscosity in a preferable temperature range (for example, 60 to 120°C). Incidentally, in the present invention, the softening point is a value measured by the softening point test (ring and ball) method (measurement condition: in accordance with JIS-K7234:1986).

In the epoxy resin (A) used in the present invention, the epoxy equivalent is preferably from 150 to 450 g/eq from the viewpoint of increasing the crosslinking density of a thermally cured product. Note that, in the present invention, the epoxy equivalent refers to the number of grams of a resin containing 1 gram equivalent of epoxy group (g/eq).

The weight average molecular weight of the epoxy resin (A) is usually preferably less than 10000 and more preferably 5000 or less. The lower limit is not particularly limited, but is practically 300 or more.

The weight average molecular weight is a value obtained by GPC (Gel Permeation Chromatography) analysis (hereinafter, the same applies to other resins unless otherwise specified).

The content of the epoxy resin (A) is preferably from 20 to 70 parts by mass, more preferably from 30 to 60 parts by mass, and still more preferably from 40 to 60 parts by mass based on 100 parts by mass of the total content of the epoxy resin (A) and the polymer component (D).

### <(B) Epoxy resin curing agent>

As the epoxy resin curing agent (B), optional curing agents such as amines, acid anhydrides, and polyhydric phenols can be used. In the present invention, a latent curing agent is preferably used from the viewpoint of having a low melt viscosity, and being capable of providing a film adhesive that exhibits curability at a high temperature more than a certain temperature, has rapid curability, and further has high storage stability that enables long-term storage at room temperature.

Examples of the latent curing agent include a dicyandiamide compound, an imidazole compound, a curing catalyst composite-based polyhydric phenol compound, a hydrazide compound, a boron trifluoride-amine complex, an amine imide compound, a polyamine salt, a modified product thereof, or those of a microcapsule type. These may be used singly, or in combination of two or more types thereof. Use of an imidazole compound is more preferable from the viewpoint of providing even better latency (properties of excellent stability at room temperature and exhibiting curability by heating) and providing a more rapid curing rate.

The content of the epoxy resin curing agent (B) in the adhesive composition may be set, if appropriate, according to the type and reaction form of the curing agent. For example, the content can be 0.5 to 100 parts by mass, may be 1 to 80 parts by mass or 2 to 50 parts by mass, and is also preferably 4 to 20 parts by mass based on 100 parts by mass of the epoxy resin (A). In addition, in the case of using an imidazole compound as the epoxy resin curing agent (B), the content of the imidazole compound is preferably from 0.5 to 10 parts by mass and more preferably from 2 to 9 parts by mass based on 100 parts by mass of the epoxy resin (A). Setting the content of the epoxy resin curing agent (B) to the preferable lower limit or more can further reduce the curing time. On the other hand, setting the content to the preferable upper limit or less can suppress excessive remaining of the curing agent in the film adhesive. As a result, moisture absorption by the remaining curing agent can be suppressed, and thus the reliability of the semiconductor device can be improved.

### <(C) Polyrotaxane compound>

The polyrotaxane compound is a polymer compound having a pseudo-polyrotaxane, in which ring molecules are threaded, through their opening, on a linear molecule, while having a terminal stopper at each end.

The polyrotaxane compound used in the present invention may be one kind or two or more kinds.

### -Linear molecule-

The linear molecule used to form the polyrotaxane compound is not particularly limited as long as it can be used to thread each ring molecule through their opening.

Examples of such a linear molecule include polyvinyl alcohol, polyolefin-based resin, polyester resin, polyvinyl chloride resin, polystyrene-based resin, acrylic resin, polycarbonate resin, polyurethane resin, polydienes, polyalkylene glycol, polyimide, melamine resin, and epoxy resin. Specific examples thereof include each linear molecule described in paragraph [0030] of JP-A-2016-58138 or paragraph [0026] of JP-A-2015-203037, the descriptions of which are incorporated herein.

Among them, those selected from polyethylene glycol, polyisoprene, polyisobutylene, polybutadiene, polypropylene glycol, polytetrahydrofuran, polydimethylsiloxane, polyethylene, polypropylene, polyvinyl alcohol, or polyvinyl methyl ether are preferable, and polyethylene glycol is more preferable.

The weight-average molecular weight of the linear molecule is not particularly limited, but is, for example, preferably 1000 or larger, more preferably from 3000 to 100000, and still more preferably from 6000 to 50000.

### -Ring molecule-

The ring molecule used to form the polyrotaxane compound is a molecule having a circular molecular structure and having an opening through which the linear molecule penetrates at the center thereof. Such a ring molecule is not particularly limited, and examples thereof include cyclodextrin, crown ether, cryptand, macrocyclic amine, calixarene, and cyclophane. Among them, cyclodextrin (α-cyclodextrin, β-cyclodextrin, or γ-cyclodextrin) is preferable from the viewpoint of having a hydroxyl group.

The ring molecule may have a functional group, and examples of such a functional group include a hydroxyl group, a mercapto group, a carbon-carbon unsaturated group, an amino group, a nitrile group, a carboxyl group, a diazo group, an aldehyde group, and an ester group. Examples of the carbon-carbon unsaturated group include a vinyl group, an acryloyl group, a methacryloyl group, and an acetylene group.

### -Terminal stopper-

The terminal stopper used to form the polyrotaxane compound is not particularly limited as long as it is a group capable of preventing each ring molecule from being detached from the linear molecule by bonding to the linear molecule. Examples of such a group include a methyl group, an ethyl group, a butyl group, a tert-butyl group, a tert-butoxycarbonyl group, a benzyloxycarbonyl group, an acetyl group, an adamantyl group, a 2,4-dinitrophenyl group, a trityl group, a dancyl group, a 2,4,6-trinitrophenyl group, a triisopropylsilyl group, a naphthalene-derived group, and an anthracene-derived group. Among them, an adamantyl group is preferable.

The method of introducing the terminal stopper into the linear molecule is not particularly limited, and examples thereof include a method in which a compound having a group capable of reacting with a terminal functional group of the linear molecule and the terminal stopper is reacted (bonded) with the terminal functional group of the linear molecule by a common method.

The polyrotaxane compound may be formed by the linear molecule, each ring molecule, and the terminal stoppers, and the combination of the linear molecule, each ring molecule, and the terminal stoppers is also not particularly limited. Preferably, a combination of polyethylene glycol as the linear molecule, cyclodextrin as each ring molecule, and an adamantyl group as the terminal stopper is preferable.

The polyrotaxane compound may be synthesized, or a commercially available product may be used.

In the case of synthesis, the synthesis method is not particularly limited, and for example, the method described in each of the publications described in WO 2005/080469 A1, WO 2005-108464 A1, or paragraph [0042] of Patent Literature 2 can be consulted. Examples of a commercially available product of the polyrotaxane compound include "SeRM (registered trademark) Super Polymer" series (manufactured by ASM Inc).

The content of the polyrotaxane compound (C) is preferably from 5 to 15 parts by mass, more preferably from 5 to 12 parts by mass, and still more preferably from 5 to 10 parts by mass, based on total 100 parts by mass of the contents of the epoxy resin (A) and the polymer component (D).

### <(D) Polymer component>

The polymer component (D) has only to be a component that suppresses a film tack property at normal temperature (25°C) (property that the film state is likely to change by even a little temperature change) and imparts sufficient adhesiveness and film formability (film forming property) when the film adhesive is formed. Examples thereof include a natural rubber, a butyl rubber, an isoprene rubber, a chloroprene rubber, an ethylene-vinyl acetate copolymer, an ethylene-(meth)acrylic acid copolymer, an ethylene-(meth)acrylic acid ester copolymer, a polybutadiene resin, a polycarbonate resin, a thermoplastic polyimide resin, polyamide resins such as 6-nylon and 6,6-nylon, a phenoxy resin, a (meth)acrylic resin, polyester resins such as polyethylene terephthalate and polybutylene terephthalate, a polyamideimide resin, a fluororesin, and a polyurethane resin. These polymer components (D) may be used singly, or in combination of two or more types thereof. As the polymer component (D), a phenoxy resin, a (meth)acrylic resin, or a polyurethane resin is preferable, and a phenoxy resin is more preferable.

The weight-average molecular weight of the polymer component (D) is 10000 or more. The upper limit is not particularly limited, but is practically 5000000 or less.

The weight-average molecular weight of the polymer component (D) is a value determined by GPC (Gel Permeation Chromatography) in terms of polystyrene. Hereinafter, the value of the weight-average molecular weight of the specific polymer component (D) has the same meaning.

The glass transition temperature (Tg) of the polymer component (D) is preferably less than 100°C, and more preferably less than 90°C. The lower limit is preferably 0°C or higher, and more preferably 10°C or higher.

The glass transition temperature of the polymer component (D) is a glass transition temperature measured by DSC at a temperature elevation rate of 0.1°C/min. Hereinafter, the value of the glass transition temperature of the specific polymer component (D) has the same meaning.

Note that, in the present invention, with regard to the epoxy resin (A) and a resin which can have an epoxy group such as phenoxy resin of the polymer component (D), a resin having an epoxy equivalent of 500 g/eq or less is classified into the epoxy resin (A) and a resin which does not correspond to the above resin is classified into the component (D).

### (Phenoxy resin)

The phenoxy resin is not particularly limited, and a known phenoxy resin can be widely used as a film component of the film adhesive.

The phenoxy resin can be obtained by a usual method. For example, the phenoxy resin can be obtained by a reaction of a bisphenol or biphenol compound with epihalohydrin such as epichlorohydrin, or a reaction of liquid epoxy resin with a bisphenol or biphenol compound.

The weight-average molecular weight of the phenoxy resin is preferably 10000 or larger and more preferably from 10000 to 100000.

Further, the amount of epoxy group remaining in a small amount in the phenoxy resin is an epoxy equivalent of preferably 5000 g/eq or more.

The glass transition temperature (Tg) of the phenoxy resin is preferably less than 100°C, and more preferably less than 90°C. The lower limit is preferably 0°C or higher, and more preferably 10°C or higher.

### ((Meth)acrylic resin)

The (meth)acrylic resin is not particularly limited, and a resin composed of a known (meth)acrylic copolymer can be widely used as a film component of the film adhesive.

Examples of the (meth)acrylic resin include poly(meth)acrylic acid esters and derivatives thereof. Examples thereof include copolymers containing, as a monomer component, 2-hydroxyethyl acrylate, 2-hydroxyethyl methacrylate, 2-hydroxypropyl acrylate, 2-hydroxypropyl methacrylate, acrylic acid, methacrylic acid, itaconic acid, glycidylmethacrylate, glycidylacrylate, and the like.

In addition, preferred is a copolymer using, as a monomer, a (meth)acrylic acid ester having a cyclic skeleton (e.g., a (meth)acrylic acid cycloalkyl ester, a (meth)acrylic acid benzyl ester, isobornyl (meth)acrylate, dicyclopentanyl (meth)acrylate, dicyclopentenyl (meth)acrylate, dicyclopentenyloxyethyl (meth)acrylate, imide(meth)acrylate), or the like.

Also preferred is a monomer component such as a (meth)acrylic acid alkyl ester having an alkyl having 1 to 18 carbon atoms (e.g., methyl (meth)acrylate, ethyl (meth)acrylate, propyl (meth)acrylate, butyl (meth)acrylate).

Also, these monomer components may be copolymerized with vinyl acetate, (meth)acrylonitrile, styrene, or the like.

Further, a (meth)acrylic resin having a hydroxy group is preferable because compatibility with the epoxy resin is favorable.

The weight-average molecular weight of the (meth)acrylic copolymer is preferably 10000 to 2000000, and more preferably 100000 to 1500000. By adjusting the weight-average molecular weight to a level within the preferable range, a tack property can be reduced and increase in the melt viscosity can also be suppressed.

The glass transition temperature of the (meth)acrylic copolymer is in a range of preferably -35°C to 50°C, more preferably -10°C to 50°C, still more preferably 0°C to 40°C, and particularly preferably 0°C to 30°C. By adjusting the glass transition temperature to a level within the preferable range, a tack property can be reduced and generation of voids between the semiconductor wafer and the film adhesive, and the like can be suppressed.

### <Polyurethane resin>

The polyurethane resin is a polymer having a urethane (carbamic acid ester) bond in the main chain. The polyurethane resin has a constituent unit derived from a polyol and a constituent unit derived from a polyisocyanate, and may further have a constituent unit derived from a polycarboxylic acid. One kind of the polyurethane resin may be used singly, or two or more kinds thereof may be used in combination.

The Tg of the polyurethane resin is usually 100°C or lower, preferably 60°C or lower, more preferably 50°C or lower, and also preferably 45°C or lower.

The weight-average molecular weight of the polyurethane resin is not particularly limited, and a polyurethane resin having a weight-average molecular weight within a range of 5000 to 500000 is usually used.

The polyurethane resin can be synthesized by an ordinarily method, and can also be obtained from the market. Examples of a commercially available product that can be applied as the polyurethane resin include Dynaleo VA-9320M, Dynaleo VA-9310MF, or Dynaleo VA-9303MF (all manufactured by TOYOCHEM CO., LTD.).

The content of the polymer component (D) is preferably from 20 to 70 parts by mass, more preferably from 30 to 60 parts by mass, and still more preferably from 40 to 60 parts by mass, based on total 100 parts by mass of the contents of the epoxy resin (A) and the polymer component (D). The content of the polymer component (D) may be from 30 to 80 parts by mass, from 40 to 70 parts by mass, or from 40 to 60 parts by mass, based on total 100 parts by mass of the contents of the epoxy resin (A) and the polymer component (D). The rigidity and flexibility of the film adhesive before curing can be controlled by adjusting the content to such a range. The state of the film becomes favorable (film tack property is reduced), and thus film brittleness can also be suppressed.

### <(E) Inorganic filler>

As the inorganic filler (E), an inorganic filler usually used in the adhesive composition can be used without particular limitation.

Examples of the inorganic filler (E) include each inorganic powder made of ceramics, such as silica, clay, gypsum, calcium carbonate, barium sulfate, alumina (aluminum oxide), beryllium oxide, magnesium oxide, silicon carbide, silicon nitride, aluminum nitride, boron nitride; metal or alloys, such as aluminum, copper, silver, gold, nickel, chromium, lead, tin, zinc, palladium, solder; and carbons, such as carbon nanotube, carbon nanofiber, or graphene.

The average particle diameter (d50) of the inorganic filler (E) is not particularly limited, but is preferably 0.01 to 6.0 µm, preferably 0.01 to 5.0 µm, more preferably 0.1 to 3.5 µm, and still more preferably 0.1 to 1.0 µm from the viewpoint of making the film adhesive thinner. The average particle diameter (d50) is a so-called median diameter, and refers to a particle diameter at which the cumulative volume is 50% when the particle size distribution is measured by the laser diffraction scattering method and the total volume of the particles is defined as 100% in the cumulative distribution.

The Mohs hardness of the inorganic filler is not particularly limited, and is preferably 2 or more and more preferably from 2 to 9. The Mohs hardness can be measured with a Mohs hardness meter.

The inorganic filler (E) may contain a thermally conductive inorganic filler (inorganic filler having a thermal conductivity of 12 W/m·K or more) in an embodiment, or may contain a thermally non-conductive inorganic filler (inorganic filler having a thermal conductivity of less than 12 W/m·K) in an embodiment.

The inorganic filler (E) having thermal conductivity is particles made of a thermally conductive material or particles whose surfaces are coated with the thermally conductive material. The thermal conductivity of the thermally conductive material is preferably 12 W/m·K or more, and more preferably 30 W/m·K or more.

When the thermal conductivity of the thermally conductive material is the preferable lower limit or more, the amount of the inorganic filler (E) blended in order to obtain a desired thermal conductivity can be reduced. This suppresses an increase in the melt viscosity of the die attach film and can further improve how the film is embedded onto uneven portions of the substrate at the time of compression bonding to the substrate. As a result, generation of voids can be more reliably suppressed.

In the present invention, the thermal conductivity of the thermally conductive material means the thermal conductivity at 25°C, and the literature value for each material can be used. In a case where there is no description in the literatures, for example, the value measured in accordance with JIS R 1611:2010 can be used in the case of ceramics, or the value measured in accordance with JIS H 7801:2005 can be used in the case of metals in substitution for the literature value.

Examples of the inorganic filler (E) having thermal conductivity include thermally conductive ceramics, and preferred examples thereof include alumina particles (thermal conductivity: 36 W/m·K), aluminum nitride particles (thermal conductivity: 150 to 290 W/m·K), boron nitride particles (thermal conductivity: 60 W/m·K), zinc oxide particles (thermal conductivity: 54 W/m·K), silicon nitride particles (thermal conductivity: 27 W/m·K), silicon carbide particles (thermal conductivity: 200 W/m·K), and magnesium oxide particles (thermal conductivity: 59 W/m·K).

In particular, alumina particles having high thermal conductivity are preferable in terms of dispersibility and availability. Further, aluminum nitride particles and boron nitride particles are preferable from the viewpoint of having even higher thermal conductivity than that of alumina particles. In the present invention, alumina particles and aluminum nitride particles are preferable among these particles.

Additional examples of the inorganic filler (E) having thermal conductivity include metal particles having higher thermal conductivity than ceramic, and particles surface-coated with a metal. Preferred examples include a single metal filler such as silver (thermal conductivity: 429 W/m·K), nickel (thermal conductivity: 91 W/m·K), and gold (thermal conductivity: 329 W/m·K); and polymer particles such as silicone resin particles or acrylic resin particles whose surfaces are coated by these metals.

In the present invention, it is also preferable to use silica as the inorganic filler (E).

The inorganic filler (E) may be subjected to surface treatment or surface modification. Examples of the surface treatment agent used for such surface treatment or surface modification include a silane coupling agent, phosphoric acid or a phosphoric acid compound, and a surfactant. Besides the items described in the present specification, the descriptions of a silane coupling agent, or phosphoric acid or a phosphoric acid compound, and a surfactant in the section of a thermally conductive filler in WO 2018/203527 or the section of an aluminum nitride filler in WO 2017/158994 can be applied, for example.

A method of blending the inorganic filler (E) to the resin components such as the epoxy resin (A), the epoxy resin curing agent (B), the polyrotaxane compound (C), and the polymer component (D) includes a method in which a powder inorganic filler and, if necessary, a silane coupling agent, phosphoric acid or a phosphoric acid compound, and a surfactant are directly blended (integral blending method), and a method in which a slurry inorganic filler obtained by dispersing an inorganic filler treated with a surface treatment agent such as a silane coupling agent, phosphoric acid or a phosphoric acid compound, and a surfactant in an organic solvent is blended.

A method of treating the inorganic filler (E) with a silane coupling agent is not particularly limited. Examples thereof include a wet method of mixing the inorganic filler (E) and a silane coupling agent in a solvent, a dry method of mixing the inorganic filler (E) and a silane coupling agent in a gas phase, and the above integral blending method.

In particular, the aluminum nitride particles contribute to high thermal conductivity, but tend to generate ammonium ions due to hydrolysis. It is therefore preferable that the aluminum nitride particles are used in combination with a phenol resin having a low moisture absorption rate and hydrolysis is suppressed by surface modification. As a surface modification method of the aluminum nitride, a method of providing a surface layer with an oxide layer of aluminum oxide to improve water proofness and then performing surface treatment with phosphoric acid or a phosphoric acid compound to improve affinity with the resin is particularly preferable.

The silane coupling agent is a compound in which at least one hydrolyzable group such as an alkoxy group or an aryloxy group is bonded to a silicon atom. In addition to these groups, an alkyl group, an alkenyl group, or an aryl group may be bonded to the silicon atom. The alkyl group is preferably an alkyl group substituted with an amino group, an alkoxy group, an epoxy group, or a (meth)acryloyloxy group, and more preferably an alkyl group substituted with an amino group (preferably, a phenylamino group), an alkoxy group (preferably, a glycidyloxy group), or a (meth)acryloyloxy group.

Examples of the silane coupling agent include 2-(3,4-epoxycyclohexyl) ethyltrimethoxysilane, 3-glycidyloxypropyltrimethoxysilane, 3-glycidyloxypropyltriethoxysilane, 3-glycidyloxypropylmethyldimethoxysilane, 3-glycidyloxypropylmethyldiethoxysilane, dimethyldimethoxysilane, dimethyldiethoxysilane, methyltrimethoxysilane, methyltriethoxysilane, phenyltrimethoxysilane, phenyltriethoxysilane, N-phenyl-3-aminopropyltrimethoxysilane, 3-methacryloyloxypropylmethyldimethoxysilane, 3-methacryloyloxypropyltrimethoxysilane, 3-methacryloyloxypropylmethyldiethoxysilane, and 3-methacryloyloxypropyltriethoxysilane.

The silane coupling agent and the surfactant are contained in an amount of preferably 0.1 to 25.0 parts by mass, more preferably 0.1 to 10.0 parts by mass, and further preferably 0.1 to 2.0 parts by mass based on 100 parts by mass of the inorganic filler (E).

By adjusting the content of the silane coupling agent or the surfactant to the preferable range, it is possible to suppress peeling at the adhesion interface due to volatilization of an excessive silane coupling agent and surfactant in a heating process in semiconductor assembling (for example, a reflow process), while suppressing aggregation of the inorganic filler (E). As a result, generation of voids can be suppressed.

Examples of the shape of the inorganic filler (E) include a flake shape, a needle shape, a filament shape, a spherical shape, and a scale shape. In terms of high filling and flowability, spherical particles are preferred.

When the adhesive composition of the present invention contains the inorganic filler (E), the content of the inorganic filler (E) is preferably 45 parts by mass or less based on total 100 parts by mass of the contents of the epoxy resin (A) and the polymer component (D). Within the above range, even when the inorganic filler (E) is contained, the adhesion strength is not substantially decreased.

When the adhesive composition of the present invention contains the inorganic filler (E), the content of the inorganic filler (E) is preferably from 10 to 45 parts by mass, more preferably from 20 to 45 parts by mass, and still more preferably from 30 to 40 parts by mass based on total 100 parts by mass of the contents of the epoxy resin (A) and the polymer component (D).

### <Other components>

In addition to the epoxy resin (A), the epoxy resin curing agent (B), the polyrotaxane compound (C), the polymer component (D), and the inorganic filler (E), the adhesive composition of the present invention may further contain additives such as an organic solvent (e.g., methyl ethyl ketone), an ion trapping agent (ion capturing agent), a curing catalyst, a viscosity adjusting agent, an antioxidant, a flame retardant, and/or a coloring agent as long as the effect of the present invention is not inhibited. The adhesive composition can contain, for example, other additives described in WO 2017/158994 A.

The proportion of the total content of the epoxy resin (A), the epoxy resin curing agent (B), the polyrotaxane compound (C), and the polymer component (D) in the adhesive composition of the present invention can be, for example, 60 mass% or more, preferably 70 mass% or more, further preferably 80 mass% or more, and may also be 90 mass% or more. Also, the proportion may be 100 mass%, and can be 95 mass% or less. Even when the inorganic filler (E) is included, the proportion of the total content of the epoxy resin (A), the epoxy resin curing agent (B), the polyrotaxane compound (C), the polymer component (D), and the inorganic filler (E) in the adhesive composition of the present invention can be, for example, 60 mass% or more, preferably 70 mass% or more, further preferably 80 mass% or more, and may also be 90 mass% or more. Also, the proportion may be 100 mass%, and can be 98 mass% or less.

The adhesive composition of the present invention can be suitably used for obtaining the film adhesive of the present invention. However, the adhesive composition of the present invention is not limited to the film adhesive, and can also be suitably used for obtaining a liquid or paste adhesive, for example.

The adhesive composition of the present invention can be obtained by mixing the above components at a temperature at which the epoxy resin (A) is practically not cured. The order of mixing is not particularly limited. Resin components such as the epoxy resin (A), the polyrotaxane compound (C), and the polymer component (D) may be mixed together with a solvent, if necessary, and the epoxy resin curing agent (B) may then be mixed. Here, the polyrotaxane compound (C) may be mixed separately from the epoxy resin (A) and the polymer component (D), and for example, the epoxy resin (A) and the polymer component (D) may be mixed together with a solvent as necessary, and the epoxy resin curing agent (B) and the polyrotaxane compound (C) may then be mixed. In either case, the mixing in the presence of the epoxy resin curing agent (B) may be performed at a temperature at which the epoxy resin (A) is practically not cured, and the mixing of the resin components in the absence of the epoxy resin curing agent (B) may be performed at a higher temperature.

In addition, in the case of using the inorganic filler (E), the order of mixing of the inorganic filler (E) is not limited, but the inorganic filler (E) can be mixed at the same time as with the epoxy resin curing agent (B).

From the viewpoint of suppressing curing of the epoxy resin (A), the adhesive composition of the present invention is preferably stored under a temperature condition at 10°C or lower before use (before being formed into a film adhesive).

### [Film adhesive]

The film adhesive of the present invention is a film adhesive obtained from the adhesive composition of the present invention. Thus, the film adhesive of the present invention includes the above epoxy resin (A), epoxy resin curing agent (B), polyrotaxane compound (C), and polymer component (D). The film adhesive of the present invention may further include an inorganic filler (E). Among the additives described as other additives in the adhesive composition of the present invention, the additives other than the organic solvent, in addition to the above components, may be included.

More specifically, the film adhesive of the present invention is specified as follows:
a film adhesive including: (A) an epoxy resin; (B) an epoxy resin curing agent; (C) a polyrotaxane compound; and (D) a polymer component,
wherein the polyrotaxane compound (C) is contained in a content of 5 to 15 parts by mass based on total 100 parts by mass of contents of the epoxy resin (A) and the polymer component (D).

When the film adhesive of the present invention is formed using the adhesive composition containing an organic solvent, the solvent is usually removed from the adhesive composition by drying. Thus, the content of the solvent in the film adhesive of the present invention is 1000 ppm (ppm is on a mass basis) or less, and is usually 0.1 to 1000 ppm.

Here, the "film" in the present invention means a thin film having a thickness of 200 µm or less. The shape, size, and the like of the film are not particularly limited, and can be appropriately adjusted according to a use form.

The film adhesive of the present invention is in a state before curing, that is, in a state of B-stage.

As used herein, the film adhesive before curing refers to one in which the epoxy resin (A) is in a state before thermal curing. The film adhesive before thermal curing specifically means a film adhesive which is not exposed to a temperature condition at 25°C or higher for 72 hours or longer after preparation of the film adhesive and is not exposed to a temperature condition at higher than 30°C. On the other hand, the film adhesive after curing refers to one in which the epoxy resin (A) is thermally cured. The above description is intended to clarify the characteristics of the adhesive composition of the present invention, and the film adhesive of the present invention is not limited to one that is not exposed to a temperature condition at 25°C or higher for 72 hours or longer and is not exposed to a temperature condition at higher than 30°C.

The film adhesive of the present invention can be suitably used as a die attach film in a semiconductor production process.

The film adhesive of the present invention can be formed by preparing the adhesive composition (varnish) of the present invention, applying the composition onto a release-treated substrate film, and drying the composition as necessary. The adhesive composition usually contains an organic solvent.

As the release-treated substrate film, any release-treated substrate film that functions as a cover film of the obtained film adhesive can be used, and a publicly known film can be appropriately employed. Examples thereof include release-treated polypropylene (PP), release-treated polyethylene (PE), and release-treated polyethylene terephthalate (PET).

A publicly known method can be appropriately employed as an application method, and examples thereof include methods using a roll knife coater, a gravure coater, a die coater, a reverse coater, or the like.

The drying may be performed by removing the organic solvent from the adhesive composition without curing the epoxy resin (A) to form a film adhesive, and can be performed, for example, by holding the composition at a temperature of 80 to 150°C for 1 to 20 minutes.

The film adhesive of the present invention may be formed of the film adhesive of the present invention alone, or may have a form obtained by bonding a release-treated substrate film described above to at least one surface of the film adhesive. Further, a dicing die attach film may be formed integrally with the dicing film. The film adhesive of the present invention may be a form obtained by cutting the film into an appropriate size, or a form obtained by winding the film into a roll form.

From the viewpoint of suppressing curing of the epoxy resin (A), the film adhesive of the present invention is preferably stored under a temperature condition at 10°C or lower before use (before curing).

### [Semiconductor package and producing method thereof]

Then, preferred embodiments of a semiconductor package and a method of producing the same of the present invention will be described in detail with reference to the drawings. Note that, in the descriptions and drawings below, the same reference numerals are given to the same or corresponding components, and overlapping descriptions will be omitted. FIGS. 1 to 7 are schematic longitudinal cross-sectional views each illustrating a preferred embodiment of each step of a method of producing a semiconductor package of the present invention.

In the method of producing a semiconductor package of the present invention, as a first step, as illustrated in FIG. 1, the film adhesive 2 (die attach film 2) of the present invention is thermocompression bonded to the back surface of a semiconductor wafer 1 in which at least one semiconductor circuit is formed on a surface (that is, the back surface is a surface of the semiconductor wafer 1 on which the semiconductor circuit is not formed) to provide an adhesive layer (film adhesive 2), and then a dicing film 3 (dicing tape 3) is provided with this adhesive layer (film adhesive 2) interposed therebetween. In FIG. 1, the film adhesive 2 is illustrated smaller than the dicing film 3, but the sizes (areas) of both films are set, if appropriate, according to the purpose. For the condition of thermocompression bonding, thermocompression bonding is performed at a temperature at which the epoxy resin (A) is not thermally cured actually. Examples include the condition at a temperature of about 70°C and a pressure of about 0.3 MPa.

As the semiconductor wafer 1, a semiconductor wafer where at least one semiconductor circuit is formed on the surface can be appropriately used. Examples thereof include a silicon wafer, a SiC wafer, a GaAs wafer, and a GaN wafer. In order to provide the film adhesive (die attach film) of the present invention on the back surface of the semiconductor wafer 1, for example, a publicly known apparatus such as a roll laminator or a manual laminator can be appropriately used.

In the above, the die attach film and the dicing film are separately attached. However, when the film adhesive of the present invention is in the form of a dicing die attach film, the film adhesive and the dicing film can be integrally bonded.

Next, as a second step, as illustrated in FIG. 2, the semiconductor wafer 1 and the adhesive layer (the die attach film 2) are integrally diced to give a semiconductor chip 5 with an adhesive layer on the dicing film 3, the semiconductor chip 5 with an adhesive layer including a semiconductor chip 4 obtained by dicing the semiconductor wafer and a piece of film adhesive 2 obtained by dicing the film adhesive 2. Further, an apparatus used for dicing is not particularly limited, and a common dicing apparatus can be used, if appropriate.

Next, as the third step, the semiconductor chip 5 with an adhesive layer is peeled off from the dicing film 3. At this time, if necessary, the dicing film may be cured with energy rays to reduce the adhesion strength. The peeling can be performed by picking up the semiconductor chip 5 with an adhesive layer. Then, as illustrated in FIG. 3, the semiconductor chip 5 with an adhesive layer and the circuit board 6 are thermocompression bonded via a piece of film adhesive 2 to mount the semiconductor chip 5 with an adhesive layer on the circuit board 6. As the circuit board 6, a substrate where a semiconductor circuit is formed on the surface can be used, if appropriate. Examples of such a substrate include a print circuit board (PCB), each lead frame, and a substrate where electronic components such as a resistive element and a capacitor are mounted on a surface of the substrate.

A method of mounting the semiconductor chip 5 with an adhesive layer on such a circuit board 6 is not particularly limited, and a conventional thermocompression bonding mounting method can be appropriately adopted.

Then, as a fourth step, the piece of film adhesive 2 is thermally cured. The temperature of the thermal curing is not particularly limited as long as the temperature is equal to or higher than a temperature at which thermal curing starts in the piece of film adhesive 2, and is adjusted, if appropriate, depending on the types of the epoxy resin (A) and the epoxy resin curing agent (B) used. For example, the temperature is preferably from 100 to 180°C and more preferably from 140 to 180°C from the viewpoint of curing in a shorter time. If the temperature is too high, the components in the piece of film adhesive 2 tend to be volatilized during the curing process. This is likely to cause foaming. The duration of this thermal curing treatment may be set, if appropriate, according to the heating temperature, and can be, for example, from 10 to 120 minutes.

In the method of producing a semiconductor package of the present invention, it is preferable that the circuit board 6 and the semiconductor chip 5 with an adhesive layer are connected via a bonding wire 7 as illustrated in FIG. 4. Such a connection method is not particularly limited, and a publicly known method, for example, a wire bonding method or a TAB (Tape Automated Bonding) method can be appropriately employed.

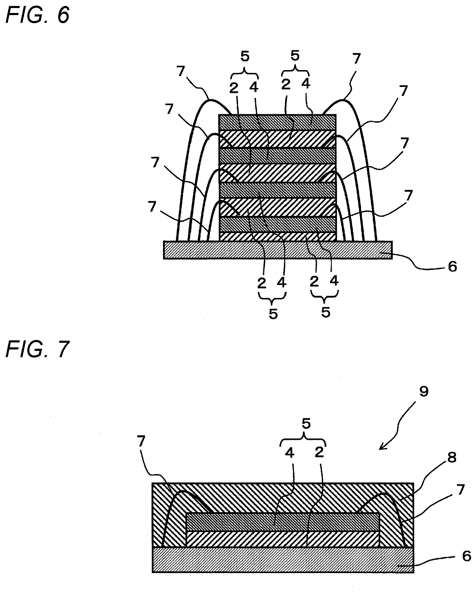

Further, a plurality of semiconductor chips 4 can be stacked by thermocompression bonding another semiconductor chip 4 to a surface of the mounted semiconductor chip 4, performing thermal curing, and then connecting the semiconductor chips 4 again to the circuit board 6 by wire bonding. Examples of the stacking method include a method of stacking the semiconductor chips in slightly different positions as illustrated in FIG. 5, and a method of stacking the semiconductor chips by increasing the thicknesses of the piece of film adhesive 2 of the second layer or later and thereby embedding the bonding wire 7 in each piece of film adhesive 2 as illustrated in FIG. 6.

In the method of producing a semiconductor package of the present invention, it is preferable to seal the circuit board 6 and the semiconductor chip 5 with an adhesive layer by using a sealing resin 8 as illustrated in FIG. 7. In this way, the semiconductor package 9 can be obtained. The sealing resin 8 is not particularly limited, and a publicly known sealing resin that can be used for the production of the semiconductor package can be used, if appropriate. In addition, a sealing method using the sealing resin 8 is not particularly limited, and a routinely conducted method can be employed.

The semiconductor package of the present invention is produced by the above-described method of producing a semiconductor package. At least one site disposed between a semiconductor chip and a circuit board or between semiconductor chips is bonded with a thermally cured body of the film adhesive of the present invention. The semiconductor package of the present invention is preferably a wire-bonding type semiconductor package including a thermally cured product of the film adhesive of the present invention.

### EXAMPLES

Hereinafter, the present invention will be described in more detail based on Examples and Comparative Examples. However, the present invention is not limited to the following Examples.

In Examples and Comparative Examples, the room temperature means 25°C, MEK is methyl ethyl ketone, and PET is polyethylene terephthalate. "%" and "part" are on a mass basis unless otherwise specified.

### [Example 1]

In a 1000-mL separable flask, 50 parts by mass of HP-7200 (dicyclopentadiene-type epoxy resin; manufactured by DIC Corporation) as an epoxy resin, 50 parts by mass of YP-50 (phenoxy resin; Tg 84°C; manufactured by NIPPON STEEL CHEMICAL & MATERIALS CO., LTD.) as a polymer component, and 30 parts by mass of MEK were heated and stirred at a temperature of 110°C for 2 hours to prepare a resin varnish.

Further, this resin varnish was transferred to a 800-mL planetary mixer, 10 parts by mass of SH2400P (trade name; linear molecule: polyethylene glycol (weight-average molecular weight: 20000), ring molecule: cyclodextrin, terminal stopper: adamantyl group; manufactured by ASM) as a polyrotaxane compound and 2 parts by mass of 2PHZ-PW (trade name; imidazole-type curing agent; manufactured by SHIKOKU KASEI HOLDINGS CORPORATION) as an epoxy resin curing agent were added, and the mixture was stirred and mixed at room temperature for 1 hour, and then vacuum-defoamed to prepare a mixed varnish.

Thereafter, the resulting mixed varnish was applied onto a release-treated PET film having a thickness of 20 µm and then dried by heating at 130°C for 10 minutes to obtain a film adhesive with a release film, having a length of 300 mm, a width of 200 mm, and a thickness of the film adhesive of 5 µm.

### [Example 2]

A film adhesive with a release film was produced in the same manner as in Example 1 except that the amount of the polyrotaxane compound used in Example 1 was changed to 5 parts by mass.

### [Example 3]

A film adhesive with a release film was produced in the same manner as in Example 1 except that instead of SH2400P, 10 parts by mass of SH1300P (trade name; linear molecule: polyethylene glycol (weight-average molecular weight: 11000), ring molecule: cyclodextrin, terminal stopper: adamantyl group; manufactured by ASM) was used during preparation of the mixed varnish in Example 1.

### [Example 4]

A film adhesive with a release film was produced in the same manner as in Example 1 except that instead of SH2400P, 5 parts by mass of SH1300P was used during preparation of the mixed varnish in Example 1.

### [Example 5]

A film adhesive with a release film was produced in the same manner as in Example 1 except that 40 parts by mass of SO-C2 (trade name; silica filler; manufactured by Admatechs) was added during preparation of the mixed varnish in Example 1.

### [Example 6]

A film adhesive with a release film was produced in the same manner as in Example 2 except that 40 parts by mass of SO-C2 was added during preparation of the mixed varnish in Example 2.

### [Example 7]

A film adhesive with a release film was produced in the same manner as in Example 6 except that the epoxy resin used in Example 6 was changed to HP-4710 (trade name; naphthalene-type epoxy resin; manufactured by Nippon Kayaku Co., Ltd.).

### [Comparative Example 1]

A film adhesive with a release film was produced in the same manner as in Example 1 except that no polyrotaxane compound was used during preparation of the mixed varnish in Example 1.

### [Comparative Example 2]

A film adhesive with a release film was produced in the same manner as in Example 1 except that the amount of the polyrotaxane compound used in Example 1 was changed to 3 parts by mass.

### [Comparative Example 3]

A film adhesive with a release film was produced in the same manner as in Example 1 except that the amount of the polyrotaxane compound used in Example 1 was changed to 3 parts by mass and 40 parts by mass of SO-C2 was added to the mixed varnish.

### [Comparative Example 4]

A film adhesive with a release film was produced in the same manner as in Example 1 except that instead of SH2400P, 3 parts by mass of SH1300P was used during preparation of the mixed varnish in Example 1.

### [Comparative Example 5]

A film adhesive with a release film was produced in the same manner as in Example 1 except that instead of SH2400P, 3 parts by mass of SH1300P was used during preparation of the mixed varnish in Example 1 and 40 parts by mass of silica filler SO-C2 was added to the mixed varnish.

### [Comparative Example 6]

A film adhesive with a release film was produced in the same manner as in Example 1 except that the amount of the polyrotaxane compound used in Example 1 was changed to 20 parts by mass.

### [Comparative Example 7]

A film adhesive with a release film was produced in the same manner as in Example 1 except that instead of SH2400P, 20 parts by mass of SH1300P was used during preparation of the mixed varnish in Example 1.

### [Comparative Example 8]

A film adhesive with a release film was produced in the same manner as in Example 1 except that ethylene glycol diglycidyl ether (manufactured by Tokyo Chemical Industry Co., Ltd.) was used as the epoxy resin in Example 1.

Table 1 shows the compositions of the film adhesives prepared in the respective Examples or Comparative Examples. An empty cell means that a corresponding component is not contained.

The film adhesives of Examples or Comparative Examples obtained above were measured for warping and adhesion strength.

Table 1 collectively provides the results.

### <To measure warping>

Each obtained film adhesive with a release film was stuck to a glass plate having a length of 100 mm, a width of 100 mm, and a thickness of 0.05 mm under conditions at a temperature of 60°C and a pressure of 0.3 MPa while using a manual laminator (trade name: FM-114, manufactured by Technovision, Inc.), and the release film was detached from the film adhesive to produce a test body. The test body produced was held at 180°C for 1 hour in a thermostat, so that the film adhesive was thermally cured. Thereafter, the test body was taken out from the thermostat and cooled to room temperature. Then, warping of the test body was measured.

The warping was measured by placing the test body on a surface plate while a surface having the film adhesive attached faced upward, and using a gauge to measure the height from the surface of the surface plate to the warped end of the test body. When the test body is placed as described above, the four sides of the test body warp toward the upper side of the surface plate (the surface having attached the film adhesive of the test body) in a state where the vicinity of the center of the surface of the test body is in contact with the surface plate. The warping was measured at a side opposite to the side with the largest warping among the four sides of the test body. The same measurement was performed on three test bodies, and averaged.

### <To measure adhesion strength>

The film adhesive with a release film as obtained in each Example or Comparative Example was first bonded to one surface of a dummy silicon wafer (size: 8 inch, thickness: 0.35 mm) by using a manual laminator (trade name: FM-114; manufactured by Technovision, Inc.) at a temperature of 70°C and a pressure of 0.3 MPa. Thereafter, the release film was peeled off from the film adhesive. Then, a dicing tape (trade name: K-13, manufactured by Furukawa Electric Co., Ltd.) and a dicing frame (trade name: DTF2-8-1H001, manufactured by DISCO Corporation) were bonded on a surface of the film adhesive opposite to the dummy silicon wafer, by using the same manual laminator under conditions at room temperature and a pressure of 0.3 MPa. Then, dicing was performed from the dummy silicon wafer side to form squares each having a size of 2 mm × 2 mm by using a dicing apparatus (trade name: DFD-6340, manufactured by DISCO Corporation) equipped with two axes of dicing blades (Z1: NBC-ZH2050 (27HEDD), manufactured by DISCO Corporation/Z2: NBC-ZH127F-SE(BC), manufactured by DISCO Corporation) to prepare a dummy chip (semiconductor chip) with a film adhesive piece (adhesive layer) on the dicing film.

Next, the dummy chip with a film adhesive was picked up from the dicing tape by using a die bonder (trade name: DB-800, manufactured by Hitachi High-Tech Corporation). Then, the film adhesive side of the dummy chip with a film adhesive was thermocompression bonded to the mounting surface side of a lead frame substrate (42Alloy-based, manufactured by Toppan Printing Co., Ltd.) under conditions at temperature of 130°C and a pressure of 0.1 MPa (load: 400 gf) for 0.5 seconds. This was further heated at 180°C for 1 hour in a dryer to thermally cure the film adhesive.

For the dummy chip with a film adhesive, which had been bonded on the substrate, the shear peel strength (adhesion strength) of the bonded chip against the lead frame substrate was measured by using a multipurpose bondtester (trade name: series 4000PXY, manufactured by Nordson Advanced Technology). The measurement conditions were at a stage temperature of 260°C, a head height of 25 µm, and a speed of 0.5 mm/sec.

The above respective test results are shown in the following Table.

**Table 1**

| | | | Example | | | | | | |
|---|---|---|---|---|---|---|---|---|---|
| | | | 1 | 2 | 3 | 4 | 5 | 6 | 7 |
| Film adhesive composition (parts by mass) | Polymer component | YP-50 (Phenoxy resin) | 50 | 50 | 50 | 50 | 50 | 50 | 50 |
| | Epoxy resin | HP-7200 (Dicyclopentadiene-type epoxy resin) | 50 | 50 | 50 | 50 | 50 | 50 | |
| | | HP-4710 (Naphthalene-type epoxy resin) | | | | | | | 50 |
| | | Ethylene glycol diglycidyl ether | | | | | | | |
| | Polyrotaxane compound | SH2400P | 10 | 5 | | | 10 | 5 | 5 |
| | | SH1300P | | | 10 | 5 | | | |
| | Inorganic filler | SO-C2 (Silica) | | | | | 40 | 40 | 40 |
| | Epoxy resin curing agent | 2PHZ-PW (Imidazole-type curing agent) | 2 | 2 | 2 | 2 | 2 | 2 | 2 |
| | Total solid content | | 112 | 107 | 112 | 107 | 152 | 147 | 147 |
| Characteristics | Warping (mm) | | 0 | 0 | 0 | 0.5 | 0 | 0 | 0.5 |
| | Adhesion strength (MPa) | | 72 | 75 | 58 | 62 | 58 | 65 | 78 |

**(continued)**

| | | | Comparative Example | | | | | | | |
|---|---|---|---|---|---|---|---|---|---|---|
| | | | 1 | 2 | 3 | 4 | 5 | 6 | 7 | 8 |
| Film adhesive composition (parts by mass) | Polymer component | YP-50 (Phenoxy resin) | 50 | 50 | 50 | 50 | 50 | 50 | 50 | 50 |
| | Epoxy resin | HP-7200 (Dicyclopentadiene-type epoxy resin) | 50 | 50 | 50 | 50 | 50 | 50 | 50 | |
| | | HP-4710 (Naphthalene-type epoxy resin) | | | | | | | | |
| | | Ethylene glycol diglycidyl ether | | | | | | | | 50 |
| | Polyrotaxane compound | SH2400P | | 3 | 3 | | | 20 | | 10 |
| | | SH1300P | | | | 3 | 3 | | 20 | |
| | Inorganic filler | SO-C2 (Silica) | | | 40 | | 40 | | | |
| | Epoxy resin curing agent | 2PHZ-PW (Imidazole-type curing agent) | 2 | 2 | 2 | 2 | 2 | 2 | 2 | 2 |
| | Total solid content | | 102 | 105 | 145 | 105 | 145 | 122 | 122 | 112 |
| Characteristics | Warping (mm) | | 10 | 10 | 8 | 10 | 9 | 0 | 0 | 0 |
| | Adhesion strength (MPa) | | 68 | 75 | 68 | 61 | 58 | 18 | 15 | 15 |

### <Notes in Table>

In the above Table, the units of numerical values described in the rows of "Epoxy resin", "Polymer component", "Inorganic filler", "Polyrotaxane compound", and "Epoxy resin curing agent" are all "parts by mass".

The adhesive compositions of Comparative Examples 1 to 5 are either free of a polyrotaxane compound or the content thereof is smaller than that specified in the present invention. The film adhesives formed using these adhesive compositions resulted in warping of 8 mm or more.

The adhesive compositions of Comparative Example 6 and 7 contain a polyrotaxane compound in an amount larger than that specified in the present invention. The film adhesives formed using these adhesive compositions resulted in adhesion strength of 18 MPa or less, which is poor adhesion strength.

The adhesive composition of Comparative Example 8 does not use an epoxy resin having a fused ring structure. The film adhesive formed using the adhesive composition resulted in adhesion strength of 15 MPa, which is poor adhesion strength.

By contrast, the film adhesives formed using the adhesive compositions of Examples 1 to 7 satisfying the requirements of the present invention had a warping of 0 to 0.5 mm and a shear adhesion strength of 58 MPa or more. This has demonstrated that use of the adhesive composition of the present invention makes it possible to form a package with reduced warping without significantly impairing the strength of adhesion to an adherend. Further, it has been found that a sufficiently high adhesion strength can be maintained even when an inorganic filler is contained.

Having described our invention as related to the present embodiments, it is our intention that the invention not be limited by any of the details of the description, unless otherwise specified, but rather be construed broadly within its spirit and scope as set out in the accompanying claims.

The present application claims priority of Patent Application No. 2022-075368 filed in Japan on April 28, 2022, which is herein incorporated by reference as part of the present specification.

### DESCRIPTION OF SYMBOLS

- 1: Semiconductor wafer
- 2: Adhesive layer (film adhesive)
- 3: Dicing film (dicing tape)
- 4: Semiconductor chip
- 5: Semiconductor chip with film adhesive
- 6: Circuit board
- 7: Bonding wire
- 8: Sealing resin
- 9: Semiconductor package

## Claims

1. An adhesive composition, comprising:
an epoxy resin (A) having a fused ring structure;
an epoxy resin curing agent (B);
a polyrotaxane compound (C); and
a polymer component (D),
wherein the polyrotaxane compound (C) is contained in a content of 5 to 15 parts by mass based on total 100 parts by mass of contents of the epoxy resin (A) and the polymer component (D).

2. The adhesive composition according to claim 1, wherein the epoxy resin (A) comprises a dicyclopentadiene-type epoxy resin.

3. The adhesive composition according to claim 1 or 2, wherein the polymer component (D) comprises a phenoxy resin.

4. The adhesive composition according to any one of claims 1 to 3, comprising (E) an inorganic filler.

5. A film adhesive, which is obtainable from the adhesive composition according to any one of claims 1 to 4.

6. The film adhesive according to claim 5, which has a thickness of 1 to 80 µm.

7. A method of producing a semiconductor package, comprising:
a first step of providing an adhesive layer by thermocompression bonding the film adhesive according to claim 5 or 6 to a back surface of a semiconductor wafer in which a semiconductor circuit is formed on a surface, and providing a dicing film with the adhesive layer interposed between the back surface and the dicing film;
a second step of integrally dicing the semiconductor wafer and the adhesive layer to obtain a semiconductor chip with an adhesive layer, the semiconductor chip including the semiconductor chip and a piece of the film adhesive on the dicing film;
a third step of removing the dicing film from the semiconductor chip with an adhesive layer and thermocompression bonding the semiconductor chip with an adhesive layer and a circuit board via the adhesive layer; and
a fourth step of thermally curing the adhesive layer.

8. A semiconductor package, which is obtainable by the producing method according to claim 7.

9. A wire bonding-type semiconductor package comprising a thermally cured product of the film adhesive according to claim 5 or 6.
